(19) Europäisches Patentamt
European Patent Office
Office européen des brevets

(11) **EP 4 571 418 A1**

(12) **EUROPEAN PATENT APPLICATION**

(43) Date of publication:
**18.06.2025 Bulletin 2025/25**

(21) Application number: **23215687.7**

(22) Date of filing: **11.12.2023**

(51) International Patent Classification (IPC):
*G03F 7/20* $^{(2006.01)}$

(52) Cooperative Patent Classification (CPC):
**G03F 7/70605; G03F 7/70633; G03F 7/70641; G03F 7/706845**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicant: **ASML Netherlands B.V.**
**5500 AH Veldhoven (NL)**

(72) Inventor: **LEMMERS, Dorus**
**5500 AH Veldhoven (NL)**

(74) Representative: **ASML Netherlands B.V.**
**Corporate Intellectual Property**
**P.O. Box 324**
**5500 AH Veldhoven (NL)**

(54) **HOLISTIC CALIBRATION**

(57)    A method is provided for measuring a characteristic feature or property of a sub-target (e.g., a component of an integrated circuit, IC, fabricated using a lithography production process). The sub-target is located on a target, which includes one or more other sub-targets. The method involves arranging each of the sub-targets in a plurality of disjunct positions within an illumination spot of electromagnetic radiation and measuring the intensity of electromagnetic radiation diffracted from each of the sub-targets at those respective positions. Corrected intensities of electromagnetic radiation diffracted by the corresponding sub-target are determined.

Fig. 7

**Description**

BACKGROUND

Field of the Invention

The present invention relates to methods and apparatus usable, for example, in the manufacture of devices by lithographic techniques, and to methods of manufacturing devices using lithographic techniques. The invention relates more particularly to a method of performing a measurement on a sub-target in a calibration procedure, and a metrology apparatus for performing the same.

BACKGROUND ART

A lithographic apparatus is a machine that applies a desired pattern onto a substrate, usually onto a target portion of the substrate. A lithographic apparatus can be used, for example, in the manufacture of integrated circuits (ICs). In that instance, a patterning device, which is alternatively referred to as a mask or a reticle, may be used to generate a circuit pattern to be formed on an individual layer of the IC. This pattern can be transferred onto a target portion (e.g. including part of a die, one die, or several dies) on a substrate (e.g., a silicon wafer). Transfer of the pattern is typically via imaging onto a layer of radiation-sensitive material (resist) provided on the substrate. In general, a single substrate will contain a network of adjacent target portions that are successively patterned. These target portions are commonly referred to as "fields".

In the manufacture of complex devices, typically many lithographic patterning steps are performed, thereby forming functional features in successive layers on the substrate. A critical aspect of performance of the lithographic apparatus is therefore the ability to place the applied pattern correctly and accurately in relation to features laid down (by the same apparatus or a different lithographic apparatus) in previous layers. For this purpose, the substrate is provided with one or more sets of alignment marks. Each mark is a structure whose position can be measured at a later time using a position sensor, typically an optical position sensor. The lithographic apparatus includes one or more alignment sensors by which positions of marks on a substrate can be measured accurately. Different types of marks and different types of alignment sensors are known from different manufacturers and different products of the same manufacturer.

In other applications, metrology sensors are used for measuring exposed structures on a substrate (either in resist and/or after etch). A fast and non-invasive form of specialized inspection tool is a scatterometer in which a beam of radiation is directed onto a target on the surface of the substrate and properties of the scattered or reflected beam are measured. Examples of known scatterometers include angle-resolved scatterometers of the type described in US2006033921A1 and US2010201963A1. In addition to measurement of feature shapes by reconstruction, diffraction based overlay can be measured using such apparatus, as described in published patent application US2006066855A1. Diffraction-based overlay metrology using dark-field imaging of the diffraction orders enables overlay measurements on smaller targets. Examples of dark field imaging metrology can be found in international patent applications WO 2009/078708 and WO 2009/106279 which documents are hereby incorporated by reference in their entirety. Further developments of the technique have been described in published patent publications US20110027704A, US20110043791A, US2011102753A1, US20120044470A, US20120123581A, US20130258310A, US20130271740A and WO2013178422A1. The contents of all these applications are also incorporated herein by reference. These targets can be smaller than the illumination spot and may be surrounded by product structures on a wafer. Multiple gratings can be measured in one image, using a composite grating target.

In some metrology applications, such as in some scatterometers or alignment sensors, imperfections in metrology targets can result in a wavelength/polarization dependent variation in a measured value from that target. As such, correction and/or mitigation for this variation is sometimes effected by performing the same measurement using multiple different wavelengths and/or polarizations (or more generally, multiple different illumination conditions). It would be desirable to improve switching and selection of the spectral components of illumination for such metrology applications.

Process control or quality inspection using metrology techniques can be time consuming, especially if the number of targets (e.g., products fabricated by a lithography apparatus) to be characterised is large. Using more metrology apparatuses (e.g., two or more YieldStar metrology apparatuses) speeds things up; however, it also means that the intrinsic error of each of the metrology apparatuses needs to be managed and kept within acceptable levels.

Calibration is a known way to manage and control these intrinsic errors within acceptable levels. Known techniques can partially account for non-idealities (i.e., deviations) in the assumed behaviour of the metrology apparatuses but they cannot presently account for all sources of non-ideality. As a result, current calibration techniques, applied to state-of-the-art metrology apparatuses, facilitate measurement variation, across the population of metrology apparatuses, of around 5 nm $2\sigma$ (i.e., if the same feature of the same target were measured by all the metrology apparatuses in the population, 95% of the metrology apparatuses would record a numerical value that is within 5nm of the mean value for that feature). This variation is referred to as a measurement mismatch. Measurement mismatches of this magnitude (i.e.,

<10nm) are unavoidable and can be caused by unavoidable manufacturing tolerances (e.g., size, specification, etc.) of constituent parts of the metrology apparatuses.

There are two main types of calibration techniques: (I) calibration by sensing; and (II) inline calibration.

With the former, an electromagnetic response (e.g., diffracted electromagnetic radiation) of a fiducial target (e.g., a diffraction grating of known geometry) to electromagnetic radiation is measured and compared with the ideal response. Any differences between the experimental and ideal response are attributed to, or modelled as, non-idealities (i.e., deviations from assumed behaviour) of the metrology apparatus. These non-idealities can, however, be particular to the set-up of the calibration run (i.e., to the wafer with the fiducial target) and so cannot be applied to other set-ups (e.g., a customer wafer situation) without extrapolation or other forms of processing. This limits the efficacy of calibration by sensing in practice.

With current approaches of inline calibration, typically a single source of error, arising from the non-idealities of the metrology apparatus, is accounted for. This approximation reduces the accuracy in error modelling and so limits the degree with which the inline calibration technique can be used to reduce measurement error and measurement mismatch. The approximation is also a relatively poor one if the contribution of any two of the error sources are comparative in magnitude with one another (i.e., if no dominant error source exists). Attempts have been made to account for two sources of error but these approaches model the contribution from each error source in a concurrent manner. If the estimate for the first error source is incorrect (i.e. the errors attributed to the first error source are not perfectly removed), then the estimate for the second error source, which is carried out after the first, will be made worse. This causes a bias in the error estimation.

An improved calibration technique, which can facilitate the reduction of measurement mismatches across a population of metrology apparatuses, is desirable. Preferably, although not necessarily, reductions in the measurement mismatch to 0.25nm $3\sigma$ would be technically advantageous (i.e., if the same feature of the same target were measured by all the metrology apparatuses in the population, 99.7% of the metrology apparatuses would record a numerical value that is within 0.25nm of the mean value for that feature).

## SUMMARY OF THE INVENTION

Aspects of the present disclosure provide a method, a non-transitory computer program product, and an apparatus, as set out by the appended set of claims.

In general terms, the present disclosure aims to provide a new and useful method and apparatus for improving calibration procedures during a metrology measurement.

In more detail, the disclosure provides a method for measuring a characteristic feature or property of a sub-target (e.g., a component of an integrated circuit, IC, fabricated using a lithography production process). It may be performed during a calibration procedure intended to reduce the error in the measured characteristic feature or property, which may be caused by spot inhomogeneity, sensor asymmetry and/or stray light (a ghost image). The feature or property of the sub-target may be a parameter characterizing the quality of the focus of a lithography apparatus used to fabricate the sub-target. The parameter may alternatively be a parameter characterizing the overlay of two elements on the sub-target.

The sub-target is located on a target, which includes one or more other sub-targets. The other sub-targets can be structures (e.g. "simple" structures) with well-known responses to electromagnetic radiation (such as diffraction gratings) or more complex sub-targets (e.g., printed IC components). A diffraction efficiency ratio between two or more of the sub-targets may be assumed to be known.

The method involves arranging each of the sub-targets in a plurality of positions within an illumination spot of electromagnetic radiation and measuring the intensity of electromagnetic radiation diffracted from each of the sub-targets at those respective positions. Each position is located within a disjunct portion of the illumination spot (e.g., a first quarter, a second quarter, a third quarter or a fourth quarter). As a result, a measurement is taken for each sub-target in each of the disjunct portions of the illumination spot.

Each of these measured intensities is linearly related to a corrected intensity of electromagnetic radiation diffracted by the corresponding sub-target (assuming no spot inhomogeneity) according to a scaling factor and an offset parameter. The corrected intensity does not depend on the positioning of the sub-target in the illumination spot, whereas the scaling factor and offset parameters do, provided the electromagnetic system (e.g., metrology apparatus) exhibits spot inhomogeneity or sensor asymmetry and a ghost image. The scaling factors deviate from unity with increasing inhomogeneity and/or asymmetry. The offset parameter deviates from zero with a stronger ghost (i.e., more stray light). A system of equations, typically equal to the number of measurements performed, is then determined according to this linear mapping in the intensities.

The method then involves calculating the scaling factors, offset parameters and the corrected intensities by solving the system of equations. These variables are determined together (i.e., holistically). The measurement error associated with these parameters can then be determined without bias (unlike with conventional approaches which do not determine these parameters at the same time). This makes the proposed approach advantageously more effective at reducing measurement errors and hence measurement mismatch. The solving step may involve the minimization of a loss function, parameterized by the scaling factors, offset parameters, and the corrected intensities.

More accurate modelling of the effects of measurement errors in metrology apparatuses is therefore possible and the measurement mismatch across a population of metrology apparatuses can be reduced, potentially to at least as low as 0.25nm 3$\sigma$.

BRIEF DESCRIPTION OF THE DRAWINGS

Embodiments of the invention will now be described, by way of example only, with reference to the accompanying drawings, in which:

Figure 1 depicts a lithographic apparatus;
Figure 2 depicts a schematic overview of a lithographic cell;
Figure 3 depicts a schematic representation of holistic lithography, representing a cooperation between three key technologies to optimize semiconductor manufacturing;
Figure 4 depicts a schematic overview of a scatterometry apparatus used as a metrology device, which may comprise a dark field digital holographic microscope according to embodiments of the invention;
Figure 5 comprises (a) a schematic diagram of a dark field scatterometer for use in measuring targets using a first pair of illumination apertures, (b) a detail of diffraction spectrum of a target grating for a given direction of illumination, (c) a second pair of illumination apertures providing further illumination modes in using the scatterometer for diffraction based overlay measurements and (d) a third pair of illumination apertures combining the first and second pair of apertures;
Figure 6A is a schematic illustration of a target;
Figure 6B is a schematic illustration of the target from Figure 6A arranged in a plurality of configurations relative to an illumination spot.
Figure 7 is a flow diagram of an exemplary method.
Figure 8 is a schematic illustration of the target from Figure 6A arranged in a plurality of configurations relative to an illumination spot.
Figure 9 is a flow diagram of another exemplary method.
Figure 10 is a histogram, showing simulated values for the root-mean-square error (RMSE) computed across a focus offset range.

DETAILED DESCRIPTION OF EMBODIMENTS

The present disclosure proposes an inline calibration technique which can account for measurement errors caused by spot inhomogeneity and sensor asymmetry (i.e. intensity scaling factors, $\alpha_j$) and the ghost image (i.e., the offset parameters, $\gamma_j$). In the approach, the intensity scaling factors and offset parameters are determined holistically and so neither exhibits bias (e.g., overfitting). The calibration technique is, therefore, more accurate at modelling the effects of measurement errors in metrology apparatuses than conventional techniques. Following such calibration techniques, the measurement mismatch across a population of metrology apparatuses can advantageously be reduced, potentially to as low as 0.25nm 3$\sigma$.

More specifically, the method includes arranging each of *N* sub-targets in each of *M* disjunct portions of an illumination spot (i.e. portions which are different from each other and preferably do not overlap with each other, though they may share an edge with each other) and measuring the corresponding intensities ($I_{i,j}$) of electromagnetic radiation diffracted from each of the sub-targets. *M* and *N* are positive integers equal to or greater than two and *i* and *j* respectively denote the sub-target *i* from the N sub-targets and the portion j from the M disjunct portions of the illumination spot. The intensity $I_{i,j}$ is the observed (real-world) intensity of electromagnetic radiation diffracted sub-target *i* arranged at disjunct portion j of the illumination spot.

In general, there are at least *NxM* measurements (i.e., *M* measurements for each of the *N* sub-targets). Within an error, each of the observed intensities ($I_{i,j}$) is linearly related to an intensity of electromagnetic radiation diffracted from the corresponding sub-target ($I_i$) (assuming no spot homogeneity) according to a linear scaling factor, $\alpha_j$, and an offset parameter, $\gamma_j$, of the disjunct portion, *j,* of the illumination spot. That is, for each measurement: $I_{i,j} \cong \hat{I}_{i,j} = \alpha_j I_i + \gamma_j$.

Provided a sufficient number of intensity measurements ($I_{i,j}$) are taken, the system of equations $\hat{I}_{i,j} = \alpha_j I_i + \gamma_j$ can be solved. Solved here is used in a broad sense to mean numerical values for $I_i$, $\alpha_j$, and $\gamma_j$ can be determined which minimize a loss function between the observed intensities, $I_{i,j}$, and the intensities, $\hat{I}_{i,j}$. The loss function may not, however, be reduced to zero. In an example, the loss function is the total of the squares of the errors, $(\hat{I}_{i,j} - I_{i,j})^2$.

The minimization of the loss function, parameterized by both $\alpha_j$, $\gamma_j$, and $I_i$ means that $\alpha_j$, $\gamma_j$, and $I_i$ are determined holistically. The measurement error associated with these parameters can then be determined without bias (unlike with conventional approaches which do not determine these parameters at the same time). This makes the proposed approach advantageously more effective at reducing measurement errors.

Before describing embodiments of the invention in detail, it is instructive to present an example environment in which embodiments of the present invention may be implemented.

In the present document, the terms "radiation" and "beam" are used to encompass all types of electromagnetic radiation and particle radiation, including ultraviolet radiation (e.g. with a wavelength of 365, 248, 193, 157 or 126 nm), EUV (extreme ultra-violet radiation, e.g. having a wavelength in the range of about 5-100 nm), X-ray radiation, electron beam radiation and other particle radiation.

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

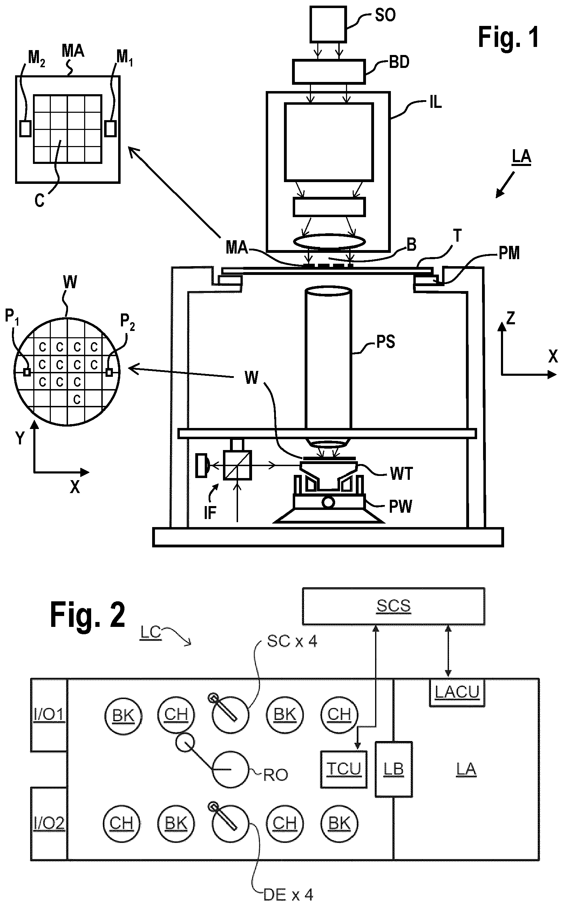

Figure 1 schematically depicts a lithographic apparatus LA. The lithographic apparatus LA includes an illumination system (also referred to as illuminator) IL configured to condition a radiation beam B (e.g., UV radiation, DUV radiation, EUV radiation or X-ray radiation), a mask support (e.g., a mask table) T constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, diffractive, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, diffractive, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference in its entirety.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support T, and is patterned by the pattern (design layout) present on patterning device MA. Having traversed the mask MA, the radiation beam B passes through the projection system PS, which focuses the beam onto a target portion C of the substrate W. With the aid of the second positioner PW and a position measurement system IF, the substrate support WT may be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks P1, P2. Although the substrate alignment marks P1, P2 as illustrated occupy dedicated target portions, they may be located in spaces between target portions. Substrate alignment marks P1, P2 are known as scribe-lane alignment marks when these are located between the target portions C.

As shown in Figure 2 the lithographic apparatus LA may form part of a lithographic cell LC, also sometimes referred to as a lithocell or (litho)cluster, which often also includes apparatus to perform pre- and post-exposure processes on a substrate W. Conventionally these include spin coaters SC to deposit resist layers, developers DE to develop exposed resist, chill plates CH and bake plates BK, e.g. for conditioning the temperature of substrates W e.g. for conditioning solvents in the resist layers. A substrate handler, or robot, RO picks up substrates W from input/output ports I/O1, I/O2, moves them between the different process apparatus and delivers the substrates W to the loading bay LB of the lithographic apparatus LA. The devices in the lithocell, which are often also collectively referred to as the track, may be under the control of a track control unit TCU that in itself may be controlled by a supervisory control system SCS, which may also control the lithographic apparatus LA, e.g. via lithography control unit LACU.

In lithographic processes, it is desirable to make frequently measurements of the structures created, e.g., for process control and verification. Tools to make such measurement may be called metrology tools MT. Different types of metrology tools MT for making such measurements are known, including scanning electron microscopes or various forms of scatterometer metrology tools MT. Scatterometers are versatile instruments which allow measurements of the parameters of a lithographic process by having a sensor in or close to the pupil or a conjugate plane with the pupil of the objective of the scatterometer, measurements usually referred as pupil based measurements, or by having the sensor in or close to an image plane or a plane conjugate with the image plane, in which case the measurements are usually referred as image or field based measurements. Such scatterometers and the associated measurement techniques are further described in patent applications US20100328655, US2011102753A1, US20120044470A, US20110249244, US20110026032 or EP1,628,164A, incorporated herein by reference in their entirety. Aforementioned scatterometers may measure gratings using light from hard X-ray (HXR), soft X-ray (SXR), extreme ultraviolet (EUV), visible to near-infrared (IR) and IR wavelength range. In case that the radiation is hard X-ray or soft X-ray, the aforementioned scatterometers may optionally be a small-angle X-ray scattering metrology tool.

In order for the substrates W exposed by the lithographic apparatus LA to be exposed correctly and consistently, it is desirable to inspect substrates to measure properties of patterned structures, such as overlay errors between subsequent layers, line thicknesses, critical dimensions (CD), shape of structures, etc. For this purpose, inspection tools and/or metrology tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection apparatus, which may also be referred to as a metrology apparatus, is used to determine properties of the substrates W, and in particular, how properties of different substrates W vary or how properties associated with different layers of the same substrate W vary from layer to layer. The inspection apparatus may alternatively be constructed to identify defects on the substrate W and may, for example, be part of the lithocell LC, or may be integrated into the lithographic apparatus LA, or may even be a stand-alone device. The inspection apparatus may measure the properties on a latent image (image in a resist layer after the exposure), or on a semi-latent image (image in a resist layer after a post-exposure bake step PEB), or on a developed resist image (in which the exposed or unexposed parts of the resist have been removed), or even on an etched image (after a pattern transfer step such as etching).

In a first embodiment, the scatterometer MT is an angular resolved scatterometer. In such a scatterometer reconstruction methods may be applied to the measured signal to reconstruct or calculate properties of the grating. Such reconstruction may, for example, result from simulating interaction of scattered radiation with a mathematical model of the target structure and comparing the simulation results with those of a measurement. Parameters of the mathematical model are adjusted until the simulated interaction produces a diffraction pattern similar to that observed from the real target.

In a second embodiment, the scatterometer MT is a spectroscopic scatterometer MT. In such spectroscopic scatterometer MT, the radiation emitted by a radiation source is directed onto the target and the reflected, transmitted or scattered radiation from the target is directed to a spectrometer detector, which measures a spectrum (i.e. a measurement of intensity as a function of wavelength) of the specular reflected radiation. From this data, the structure or profile of the target giving rise to the detected spectrum may be reconstructed, e.g. by Rigorous Coupled Wave Analysis and non-linear regression or by comparison with a library of simulated spectra.

In a third embodiment, the scatterometer MT is an ellipsometric scatterometer. The ellipsometric scatterometer allows for determining parameters of a lithographic process by measuring scattered or transmitted radiation for each polarization states. Such metrology apparatus emits polarized light (such as linear, circular, or elliptic) by using, for example, appropriate polarization filters in the illumination section of the metrology apparatus. A source suitable for the metrology apparatus may provide polarized radiation as well. Various embodiments of existing ellipsometric scatterometers are described in US patent applications 11/451,599, 11/708,678, 12/256,780, 12/486,449, 12/920,968, 12/922,587, 13/000,229, 13/033,135, 13/533,110 and 13/891,410 incorporated herein by reference in their entirety.

In one embodiment of the scatterometer MT, the scatterometer MT is adapted to measure the overlay of two misaligned gratings or periodic structures by measuring asymmetry in the reflected spectrum and/or the detection configuration, the asymmetry being related to the extent of the overlay. The two (maybe overlapping) grating structures may be applied in two different layers (not necessarily consecutive layers), and may be formed substantially at the same position on the wafer. The scatterometer may have a symmetrical detection configuration as described e.g. in co-owned patent application EP1,628,164A, such that any asymmetry is clearly distinguishable. This provides a straightforward way to measure misalignment in gratings. Further examples for overlay error between the two layers containing periodic structures as target is measured through asymmetry of the periodic structures may be found in PCT patent application publication no. WO 2011/012624 or US patent application US 20160161863, incorporated herein by reference in its entirety.

Other parameters of interest may be focus and dose. Focus and dose may be determined simultaneously by scatterometry (or alternatively by scanning electron microscopy) as described in US patent application US2011-0249244, incorporated herein by reference in its entirety. A single structure may be used which has a unique combination of critical dimension and sidewall angle measurements for each point in a focus energy matrix (FEM - also referred to as Focus Exposure Matrix). If these unique combinations of critical dimension and sidewall angle are available, the focus and dose values may be uniquely determined from these measurements.

A metrology target may be an ensemble of composite gratings, formed by a lithographic process, mostly in resist, but also after other manufacturing process, etch process for example. The pitch and line-width of the structures in the gratings may strongly depend on the measurement optics (in particular the NA of the optics) to be able to capture diffraction orders coming from the metrology targets. As indicated earlier, the diffracted signal may be used to determine shifts between two layers (also referred to 'overlay') or may be used to reconstruct at least part of the original grating as produced by the lithographic process. This reconstruction may be used to provide guidance of the quality of the lithographic process and may be used to control at least part of the lithographic process. Targets may have smaller sub-segmentation which are configured to mimic dimensions of the functional part of the design layout in a target. Due to this sub-segmentation, the targets will behave more similar to the functional part of the design layout such that the overall process parameter measurements resemble the functional part of the design layout better. The targets may be measured in an underfilled mode or in an overfilled mode. In the underfilled mode, the measurement beam generates a spot that is smaller than the overall target. In the overfilled mode, the measurement beam generates a spot that is larger than the overall target. In such overfilled mode, it may also be possible to measure different targets simultaneously, thus determining different processing parameters at the same time.

Overall measurement quality of a lithographic parameter using a specific target is at least partially determined by the measurement recipe used to measure this lithographic parameter. The term "substrate measurement recipe" may include one or more parameters of the measurement itself, one or more parameters of the one or more patterns measured, or both. For example, if the measurement used in a substrate measurement recipe is a diffraction-based optical measurement, one or more of the parameters of the measurement may include the wavelength of the radiation, the polarization of the radiation, the incident angle of radiation relative to the substrate, the orientation of radiation relative to a pattern on the substrate, etc. One of the criteria to select a measurement recipe may, for example, be a sensitivity of one of the measurement parameters to processing variations. More examples are described in US patent application US2016-0161863 and published US patent application US 2016/0370717A1incorporated herein by reference in its entirety.

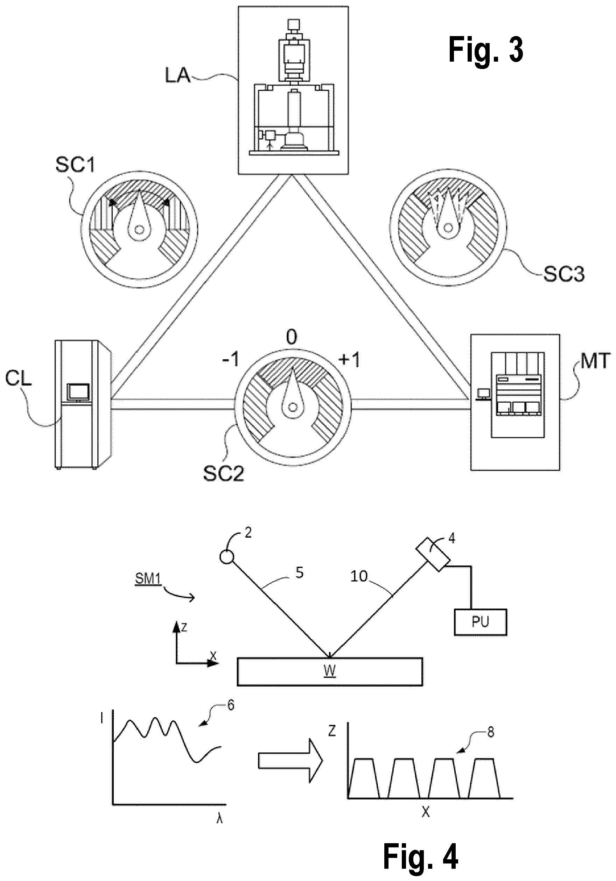

The patterning process in a lithographic apparatus LA may be one of the most critical steps in the processing which requires high accuracy of dimensioning and placement of structures on the substrate W. To ensure this high accuracy, three systems may be combined in a so called "holistic" control environment as schematically depicted in Fig. 3. One of these systems is the lithographic apparatus LA which is (virtually) connected to a metrology tool MT (a second system) and to a computer system CL (a third system). The key of such "holistic" environment is to optimize the cooperation between these three systems to enhance the overall process window and provide tight control loops to ensure that the patterning performed by the lithographic apparatus LA stays within a process window. The process window defines a range of process parameters (e.g. dose, focus, overlay) within which a specific manufacturing process yields a defined result (e.g. a functional semiconductor device) - maybe within which the process parameters in the lithographic process or patterning process are allowed to vary.

The computer system CL may use (part of) the design layout to be patterned to predict which resolution enhancement techniques to use and to perform computational lithography simulations and calculations to determine which mask layout and lithographic apparatus settings achieve the largest overall process window of the patterning process (depicted in Fig. 3 by the double arrow in the first scale SC1). The resolution enhancement techniques may be arranged to match the patterning possibilities of the lithographic apparatus LA. The computer system CL may also be used to detect where within the process window the lithographic apparatus LA is currently operating (e.g. using input from the metrology tool MET) to predict whether defects may be present due to e.g. sub-optimal processing (depicted in Fig. 3 by the arrow pointing "0" in the second scale SC2).

The metrology tool MT may provide input to the computer system CL to enable accurate simulations and predictions, and may provide feedback to the lithographic apparatus LA to identify possible drifts, e.g. in a calibration status of the lithographic apparatus LA (depicted in Fig. 3 by the multiple arrows in the third scale SC3).

Many different forms of metrology tools MT for measuring structures created using lithographic pattering apparatus can be provided. Metrology tools MT may use electromagnetic radiation to interrogate a structure. Properties of the radiation (e.g. wavelength, bandwidth, power) can affect different measurement characteristics of the tool, with shorter wavelengths generally allowing for increased resolution. Radiation wavelength has an effect on the resolution the metrology tool can achieve. Therefore, in order to be able to measure structures with features having small dimensions, metrology tools MT with short wavelength radiation sources are preferred.

Another way in which radiation wavelength can affect measurement characteristics is penetration depth, and the transparency/opacity of materials to be inspected at the radiation wavelength. Depending on the opacity and/or penetration depth, radiation can be used for measurements in transmission or reflection. The type of measurement can affect whether information is obtained about the surface and/or the bulk interior of a structure/substrate. Therefore, penetration depth and opacity are another element to be taken into account when selecting radiation wavelength for a metrology tool.

In order to achieve higher resolution for measurement of lithographically patterned structures, metrology tools MT with short wavelengths are preferred. This may include wavelengths shorter than visible wavelengths, for example in the UV, EUV, and X-ray portions of the electromagnetic spectrum. Hard X-ray methods such as Transmitted Small Angle X-ray Scattering (TSAXS) make use of the high resolution and high penetration depth of hard X-rays and may therefore operate in transmission. Soft X-rays and EUV, on the other hand, do not penetrate the target as far but may induce a rich optical response in the material to be probed. This may be due the optical properties of many semiconductor materials, and due to the structures being comparable in size to the probing wavelength. As a result, EUV and/or soft X-ray metrology tools MT may operate in reflection, for example by imaging, or by analysing diffraction patterns from, a lithographically patterned structure.

One example of a metrology apparatus, such as a scatterometer, is depicted in Figure 4. It may comprise a broadband (e.g. white light) radiation projector 2 which projects radiation 5 onto a substrate W. The reflected or scattered radiation 10 is passed to a spectrometer detector 4, which measures a spectrum 6 (i.e. a measurement of intensity I as a function of wavelength $\lambda$) of the specular reflected radiation. From this data, the structure or profile 8 giving rise to the detected spectrum may be reconstructed by processing unit PU, e.g. by Rigorous Coupled Wave Analysis and non-linear regression or by comparison with a library of simulated spectra as shown at the bottom of Figure 4. In general, for the reconstruction, the general form of the structure is known and some parameters are assumed from knowledge of the process by which the structure was made, leaving only a few parameters of the structure to be determined from the scatterometry data. Such a scatterometer may be configured as a normal-incidence scatterometer or an oblique-incidence scatterometer.

Overall measurement quality of a lithographic parameter via measurement of a metrology target is at least partially determined by the measurement recipe used to measure this lithographic parameter. The term "substrate measurement recipe" may include one or more parameters of the measurement itself, one or more parameters of the one or more patterns measured, or both. For example, if the measurement used in a substrate measurement recipe is a diffraction-based optical measurement, one or more of the parameters of the measurement may include the wavelength of the radiation, the polarization of the radiation, the incident angle of radiation relative to the substrate, the orientation of radiation relative to a pattern on the substrate, etc. One of the criteria to select a measurement recipe may, for example, be a sensitivity of one of the measurement parameters to processing variations. More examples are described in US patent application US2016-0161863 and published US patent application US 2016/0370717A1 incorporated herein by reference in its entirety.

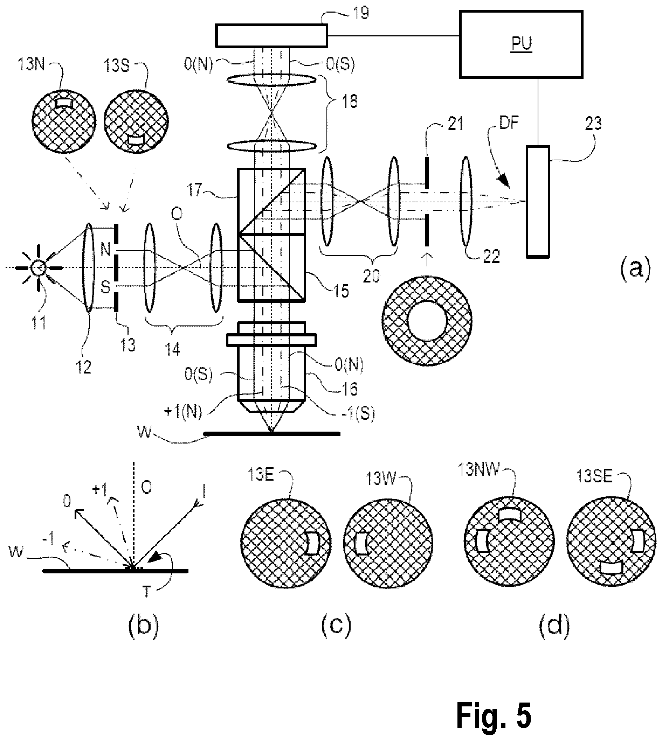

Another type of metrology apparatus is shown in Figure 5(a). A target T and diffracted rays of measurement radiation used to illuminate the target are illustrated in more detail in Figure 5(b). The metrology apparatus illustrated is of a type known as a dark field metrology apparatus. The metrology apparatus depicted here is purely exemplary, to provide an explanation of dark field metrology. The metrology apparatus may be a stand-alone device or incorporated in either the lithographic apparatus LA, e.g., at the measurement station, or the lithographic cell LC. An optical axis, which has several branches throughout the apparatus, is represented by a dotted line O. In this apparatus, light emitted by source 11 (e.g., a xenon lamp) is directed onto substrate W via a beam splitter 15 by an optical system comprising lenses 12, 14 and objective lens 16. These lenses are arranged in a double sequence of a 4F arrangement. A different lens arrangement can be used, provided that it still provides a substrate image onto a detector, and simultaneously allows for access of an intermediate pupil-plane for spatial-frequency filtering. Therefore, the angular range at which the radiation is incident on the substrate can be selected by defining a spatial intensity distribution in a plane that presents the spatial spectrum of the substrate plane, here referred to as a (conjugate) pupil plane. In particular, this can be done by inserting an aperture plate 13 of suitable form between lenses 12 and 14, in a plane which is a back-projected image of the objective lens pupil plane. In the example illustrated, aperture plate 13 has different forms, labeled 13N and 13S, allowing different illumination modes to be selected. The illumination system in the present examples forms an off-axis illumination mode. In the first illumination mode, aperture plate 13N provides off-axis from a direction designated, for the sake of description only, as 'north'. In a second illumination mode, aperture plate 13S is used to provide similar illumination, but from an opposite direction, labeled 'south'. Other modes of illumination are possible by using different apertures. The rest of the pupil plane is desirably dark as any unnecessary light outside the desired illumination mode will interfere with the desired measurement signals.

As shown in Figure 5(b), target T is placed with substrate W normal to the optical axis O of objective lens 16. The substrate W may be supported by a support (not shown). A ray of measurement radiation I impinging on target T from an angle off the axis O gives rise to a zeroth order ray (solid line 0) and two first order rays (dot-chain line +1 and double dot-chain line -1). It should be remembered that with an overfilled small target, these rays are just one of many parallel rays covering the area of the substrate including metrology target T and other features. Since the aperture in plate 13 has a finite width (necessary to admit a useful quantity of light, the incident rays I will in fact occupy a range of angles, and the diffracted rays 0 and +1/-1 will be spread out somewhat. According to the point spread function of a small target, each order +1 and -1 will be further spread over a range of angles, not a single ideal ray as shown. Note that the grating pitches of the targets and the illumination angles can be designed or adjusted so that the first order rays entering the objective lens are closely aligned with the central optical axis. The rays illustrated in Figure 5(a) and 3(b) are shown somewhat off axis, purely to enable them to be more easily distinguished in the diagram.

At least the 0 and +1 orders diffracted by the target T on substrate W are collected by objective lens 16 and directed back through beam splitter 15. Returning to Figure 5(a), both the first and second illumination modes are illustrated, by designating diametrically opposite apertures labeled as north (N) and south (S). When the incident ray I of measurement radiation is from the north side of the optical axis, that is when the first illumination mode is applied using aperture plate 13N, the +1 diffracted rays, which are labeled +1(N), enter the objective lens 16. In contrast, when the second illumination mode is applied using aperture plate 13S the -1 diffracted rays (labeled 1(S)) are the ones which enter the lens 16.

A second beam splitter 17 divides the diffracted beams into two measurement branches. In a first measurement branch, optical system 18 forms a diffraction spectrum (pupil plane image) of the target on first sensor 19 (e.g. a CCD or CMOS sensor) using the zeroth and first order diffractive beams. Each diffraction order hits a different point on the sensor, so that image processing can compare and contrast orders. The pupil plane image captured by sensor 19 can be used for focusing the metrology apparatus and/or normalizing intensity measurements of the first order beam. The pupil plane image can also be used for many measurement purposes such as reconstruction.

In the second measurement branch, optical system 20, 22 forms an image of the target T on sensor 23 (e.g. a CCD or CMOS sensor). In the second measurement branch, an aperture stop 21 is provided in a plane that is conjugate to the pupil-plane. Aperture stop 21 functions to block the zeroth order diffracted beam so that the image of the target formed on sensor 23 is formed only from the -1 or +1 first order beam. The images captured by sensors 19 and 23 are output to processor PU which processes the image, the function of which will depend on the particular type of measurements being performed. Note that the term 'image' is used here in a broad sense. An image of the grating lines as such will not be formed, if only one of the -1 and +1 orders is present.

The particular forms of aperture plate 13 and field stop 21 shown in Figure 5 are purely examples. In another embodiment of the invention, on-axis illumination of the targets is used and an aperture stop with an off-axis aperture is used to pass substantially only one first order of diffracted light to the sensor. In other examples, a two quadrant aperture may be used. This may enable simultaneous detection of plus and minus orders, as described in US2010201963A1, mentioned above. Embodiments with optical wedges (segmented prisms or other suitable elements) in the detection branch can be used to separate the orders for imaging spatially in a single image, as described in US2011102753A1, mentioned above. In yet other embodiments, 2nd, 3rd and higher order beams (not shown in Figure 5) can be used in measurements, instead of or in addition to the first order beams. In yet other embodiments, a segmented prism can be used in place of aperture stop 21, enabling both +1 and -1 orders to be captured simultaneously at spatially separate locations on image sensor 23.

In order to make the measurement radiation adaptable to these different types of measurement, the aperture plate 13 may comprise a number of aperture patterns formed around a disc, which rotates to bring a desired pattern into place. Note that aperture plate 13N or 13S can only be used to measure gratings oriented in one direction (X or Y depending on the set-up). For measurement of an orthogonal grating, rotation of the target through 90° and 270° might be implemented. Different aperture plates are shown in Figures 5(c) and (d). The use of these, and numerous other variations and applications of the apparatus are described in prior published applications, mentioned above.

A light source for metrology applications usable for concepts disclosed herein may comprise any broadband source and a color selection arrangement to select one or more colors from the broadband output. By way of an example, the radiation source may be based on a hollow core or solid core fiber such as a hollow core photonic crystal fiber (HC-PCF) or solid core photonic crystal fiber (SC-PCF). For example, in the case of a HC-PCF, the hollow core of the fiber may be filled with a gas acting as a broadening medium for broadening input radiation. Such a fiber and gas arrangement may be used to create a supercontinuum radiation source. Radiation input to the fiber may be electromagnetic radiation, for example radiation in one or more of the infrared, visible, UV, extreme UV and X-ray spectra. The output radiation may consist of or comprise broadband radiation, which may be referred to herein as white light. This is only one example of a broadband light source technology usable in methods and apparatuses disclosed herein, and other suitable technologies may instead be employed.

In one embodiment, the source is a laser produced plasma (LPP) source.

When using metrology sensors, including those described above and/or other types of metrology sensors (e.g., alignment sensors, levelling sensors), it is often desirable to control the illumination spectrum, e.g., to switch the illumination between different wavelengths (colors) and/or wavefront profiles.

In optical wafer metrology, the dominant error sources are typically spot inhomogeneity (also referred to as SpoHo), sensor asymmetry, and the ghost image.

Spot inhomogeneity refers to a variation in intensity across the illumination spot. Spot inhomogeneity means that some regions of the illuminated target receive higher intensities than other regions.

Sensor asymmetry is a broad term, which is used to refer to all sources of asymmetry in the metrology apparatus that affect the measured intensity of electromagnetic radiation from complementary diffraction orders (e.g., orders +1, -1) scattered from a point of a symmetric target. The intensities of diffraction orders, m, and diffraction order, -m, for a symmetric target should be identical. The greater the difference between the intensities of the diffraction orders, the greater the asymmetry of the sensor.

The ghost image may be formed by stray light detected by the metrology sensors. It is made up of an internal ghost and an external ghost. The internal ghost refers to electromagnetic radiation scattered (e.g., diffracted, and/or reflected) by components of the metrology apparatus, whereas the external ghost refers to electromagnetic radiation scattered by components distinct from (e.g., separate) the metrology apparatus, and which are detected by the metrology sensors. As the external ghost depends on components distinct from the metrology apparatus (e.g., the measured wafer), its magnitude is set-up dependent.

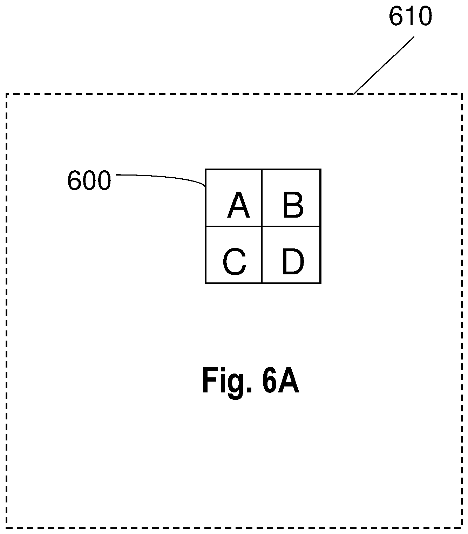

Figure 6A is a schematic illustration of a target 600, comprising four sub-targets (denoted A, B, C, and D) that are arranged on a wafer substrate 610 (not shown in later figures). In one embodiment, at least one of the sub-targets on the wafer is to be subject to quality inspection using a metrology apparatus. These sub-targets are referred to as "test sub-targets". Any one of the other sub-targets may also be a test target. Alternatively, any one of the other sub-targets may serve as a reference to facilitate calibration of the metrology apparatus. Such sub-targets are referred to as "reference sub-targets". In general, the reference sub-targets are simpler structures (e.g., diffraction gratings), which exhibit a well-known response to electromagnetic radiation, whereas the test sub-targets are more complex structures (e.g., products of a lithography production process, e.g., components of an integrated circuit, IC), the response of which is to be determined. In general, there are two or more sub-targets arranged on the wafer.

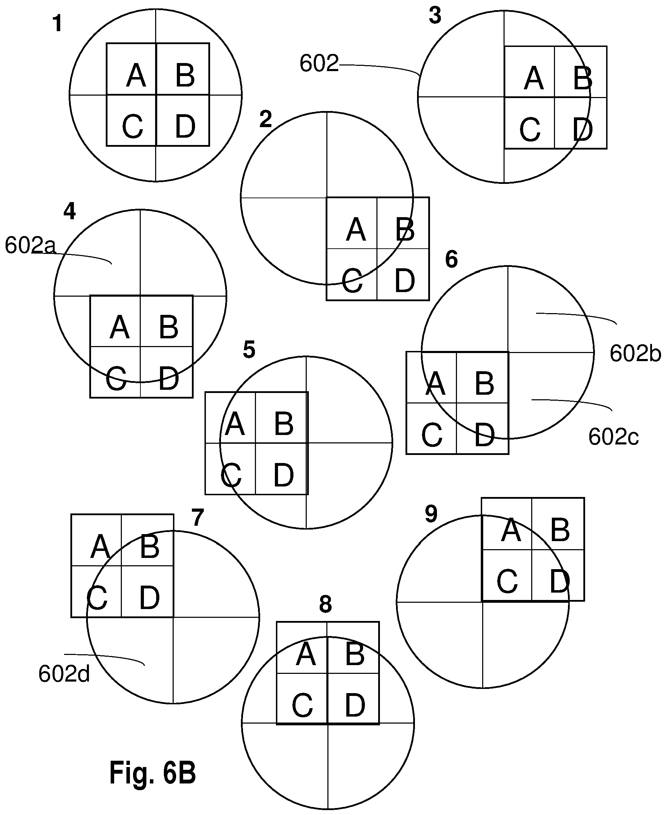

Figure 6B is a schematic illustration, showing the target 600 from Figure 6A arranged in nine configurations (or positions) with respect to an illumination spot 602. The configurations in Figure 6B are labelled from 1 to 9. In the example shown, the illumination spot can be considered as partitioned (discretized) into four disjunct portions, 602a, 602b, 602c, 602d. In general, the illumination spot can be considered as notionally partitioned into two or more disjunct portions. Each of these portions may have a size approximately at least as large as one of the sub-targets. As can be seen from Figure 6B, the nine configurations ensure that each sub-target (A, B, C, D) is arranged in each of the respective four portions of the illumination spot exactly once. To demonstrate this, Table 1 below shows the sub-target (A, B, C, D) that is arranged in each of the four quadrants (602a, 602b, 602c, 602d) for the nine configurations from Figure 6B.

*Table 1*

| Configuration | Quadrant 602a | Quadrant 602b | Quadrant 602c | Quadrant 602d |
|---|---|---|---|---|
| 1 | A | B | D | C |
| 2 | - | - | A | - |
| 3 | - | A | C | - |
| 4 | - | - | B | A |
| 5 | B | - | - | D |
| 6 | - | - | - | B |
| 7 | D | - | - | - |
| 8 | C | D | - | - |
| 9 | - | C | - | - |

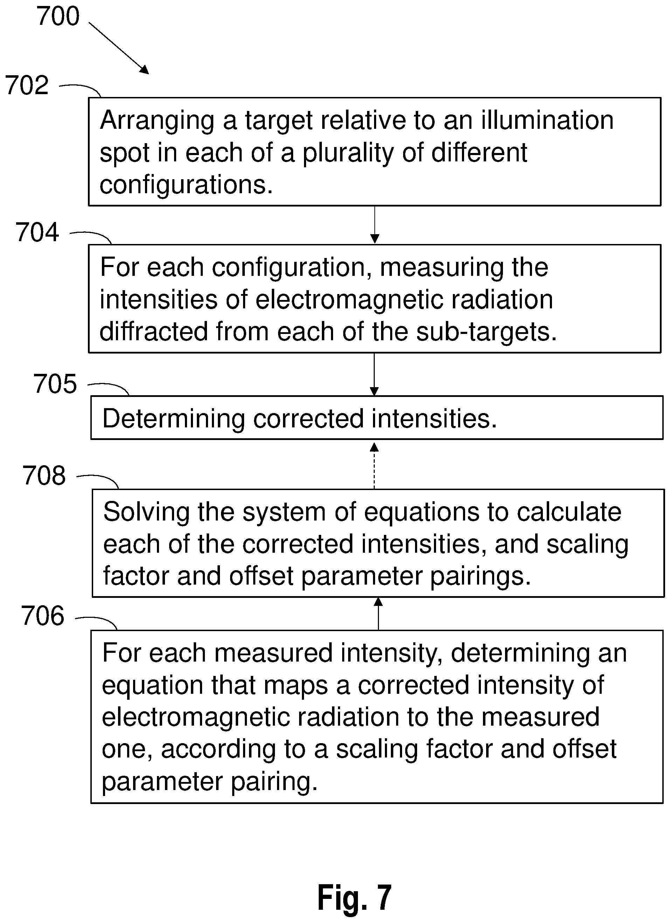

Turning to Figure 7, a method flow diagram 700, for performing a measurement on a sub-target (e.g., sub-target A of Figure 6A), is shown. The method can be performed using a metrology apparatus comprising: a stage onto which a sample (e.g., a target) may be releasably secured; an illumination branch for providing an illumination spot of electromagnetic radiation onto the stage; a drive arrangement for actuating the stage into a plurality of different positions relative to the illumination spot (e.g., used for step 702); and a measurement branch configured to detect electromagnetic radiation scattered, optionally diffracted, from within the illumination spot on the stage (e.g., used for step 704). In general, references to electromagnetic radiation diffracted from the target within the illumination spot refer to the +1 and -1 diffraction orders, although the skilled reader will appreciate that any of the diffractions and/or any combination of the diffractions could, in principle, be measured. In some metrology apparatuses, the measurement branch includes a normal and a complementary branch. The normal branch is for measuring the positive diffraction orders (i.e. +1), whereas the complementary branch is for measuring the negative diffraction orders (i.e., -1). The metrology apparatus may also include a memory for storing the output from step 708, and one or more processors for performing processing steps 708. The metrology apparatus referred to may form part of a lithography apparatus.

In step 702, a target, comprising a plurality of sub-targets (e.g., the target of Figure 6A, having four sub-targets A, B, C and D), is arranged relative to an illumination spot in each of a plurality of different configurations. The configurations are such that each of the sub-targets is arranged in each of a plurality of disjunct, portions of the illumination spot (e.g., quadrants 602a, 602b, 602c, 602d). Figure 6B is an example of the configurations into which the target could be arranged for a target comprising four sub-targets. In general, there may be $N$ sub-targets and $M$ disjunct portions of the illumination spot, where $N$ and $M$ are positive integers equal or greater than two.

In step 702, the target can be arranged relative to the illumination spot by moving the stage of the metrology apparatus upon which the target is secured relative to a stationary illumination beam. The movements of the stage may be translational (e.g., along directions, x and y, which are transverse to the illumination beam direction) and/or rotational (e.g., about the centre point of the target, which is placed coincident with the rotation axis of the stage). Alternatively, the position of the illumination beam could, in principle, be manipulated with respect to a stationary target to cause movement of the target relative to the illumination spot.

In step 704, the intensity of electromagnetic radiation diffracted from each of the sub-targets, for each configuration, is measured. In general, $NxM$ measurements may be made in step 704; however, this is not essential. For example, there may be $N$ sub-targets but not all the sub-targets are used in the method. The measured intensities are denoted $I_{i,j}$, where $i$ denotes the sub-target $i$ from the $N$ sub-targets to which the measurement relates, and $j$ denotes the portion j from the $M$ disjunct portions of the illumination spot in which the sub-target $i$ is arranged. Measurements can be made using known metrology sensors (e.g., a CCD or CMOS sensor) within the measurement branch of the metrology apparatus. The diffraction electromagnetic radiation, which propagates along the measurement branch, originating from each sub-target hits a different position (or area) on the sensor and so multiple diffracted intensities can be measured simultaneously.

Referring specifically to the configurations from Figure 6B, sixteen measurements are taken in total: four measurements for configuration "1"; one measurement for each of configurations "2", "6", "7" and "9"; and two measurements for each of configurations "3", "4", "5", and "8". Taking configuration "1" as an example, the four intensities are: $I_{1,1}$, an intensity of electromagnetic radiation diffracted from target A arranged within disjunct portion 602a of the illumination spot; $I_{2,2}$, an intensity of electromagnetic radiation diffracted from target B arranged within disjunct portion 602b of the illumination spot; $I_{3,4}$, an intensity of electromagnetic radiation diffracted from target C arranged within disjunct portion 602d of the illumination spot; and $I_{4,3}$, an intensity of electromagnetic radiation diffracted from target D arranged within disjunct portion 602c of the illumination spot.

In step 705, a corrected intensity ($I_i$) is determined for each of the intensities measured in step 704. The corrected intensity ($I_i$) is the intensity of electromagnetic radiation diffracted from the sub-target $i$ (assuming no spot inhomogeneity). $I_i$ is therefore the same, regardless of the disjunct portion j in which the sub-target $i$ is arranged. In general, there are $N$ corrected intensities, although, as has already noted, fewer than $N$ sub-targets is, in principle, possible.

Optionally, the step 705 comprises two steps 706 and 708. Note the steps 706 and 708 described below are for examples only and other steps may also be used as alternatives for determining the corrected intensity.

In step 706, an equation is determined, for each of the intensities measured in step 704, which maps the corrected intensity ($I_i$) of electromagnetic radiation to the measured intensity, according to a scaling factor and offset parameter pairing $(\alpha_j, \gamma_j)$. The scaling factors $\alpha_j$ and offset parameters $\gamma_j$ are dependent on the disjunct portion j in which the sub-target $i$ is arranged. In general, there are $M$ scaling factors and $M$ offset parameters, i.e., $2M$ variables in total. Each corrected intensity $I_i$ is linearly with the measured intensity $I_{i,j}$ according to the corresponding scaling factor and offset parameter. That is, for each measurement: $I_{i,j} \cong \alpha_j I_i + \gamma_j$.

Referring back to Figure 6B, there are: four equations for configuration "1", which are ($I_{1,1} \cong \alpha_1 I_1 + \gamma_1$, $I_{2,2} \cong \alpha_2 I_2 + \gamma_2$, $I_{3,4} \cong \alpha_4 I_3 + \gamma_4$, and $I_{4,3} \cong \alpha_3 I_4 + \gamma_3$); one equation for each of configurations "2", "6", "7", and "9", which are ($I_{1,3} \cong \alpha_3 I_1 + \gamma_3$), ($I_{2,4} \cong \alpha_4 I_2 + \gamma_4$), ($I_{4,1} \cong \alpha_1 I_4 + \gamma_1$) and ($I_{3,2} \cong \alpha_2 I_3 + \gamma_2$); and two measurements for each of configurations "3", "4", "5", and "8", which are ($I_{1,2} \cong \alpha_2 I_1 + \gamma_2$, $I_{3,3} \cong \alpha_3 I_3 + \gamma_3$), ($I_{1,4} \cong \alpha_4 I_1 + \gamma_4$, $I_{2,3} \cong \alpha_3 I_2 + \gamma_3$), ($I_{2,1} \cong \alpha_1 I_2 + \gamma_1$, $I_{4,4} \cong \alpha_4 I_4 + \gamma_4$) and ($I_{3,1} \cong \alpha_1 I_3 + \gamma_1$, $I_{4,2} \cong \alpha_2 I_4 + \gamma_2$). This makes a total of 16 measurements, 16 equations, and 12 unknown variables (i.e., $I_1, I_2, I_3, I_4, \alpha_1, \alpha_2, \alpha_3, \alpha_4, \gamma_1, \gamma_2, \gamma_3, \gamma_4$). One or more constraints, such as $I_1 = r_{12} I_2$ (in general $I_i = r_{ii'} I_{i'}$), can be introduced to increase the number of equations by one or more. $r_{ii'}$ is the ratio of the diffraction efficiencies for sub-targets $i, i'$.

In step 708, the system of equations determined in step 706 are solved in order to calculate the corrected intensities, I;, and the scaling factor and offset parameter pairings $(\alpha_j, \gamma_j)$. Solved here is used in a broad sense to mean that numerical values for $I_i$, $\alpha_j$, and $\gamma_j$ can be determined which minimize a loss function between the measured intensities, $I_{i,j}$, and an estimate for those intensities, $\hat{I}_{i,j}$. That is, $I_{i,j} \cong \hat{I}_{i,j} = \alpha_j I_i + \gamma_j$. Minimization is also used in a broad sense here to refer to a local minimum in the loss function, with varying $I_i, \alpha_j, \gamma_j$. The loss function may not, however, be reduced to zero. In an example, the loss function to be minimized is the total of the squares of the errors, $(\hat{I}_{i,j} - I_{i,j})^2$. Initialized values for $I_i, \alpha_j, \gamma_j$ can be taken as the mean measured intensity for the sub-target $i$ over each of the j spot portions, 1 and 0, respectively. Other initialized parameters are, however, possible.

The minimization of the loss function, parameterized by both $\alpha_j$, and $\gamma_j$, means that $\alpha_j$, and $\gamma_j$ are determined holistically, along with the corrected intensities $I_i$. The measurement error associated with these parameters can then be determined without bias (unlike with conventional approaches which do not determine these parameters at the same time). Example methods for finding a minimum of a constrained non-linear multivariable function are known to the skilled reader. An example is "fmincon", which is an in-built function in MATLAB® - a commercially available computing software. Other algorithms that leverage sequential quadratic programming, for optimizing (e.g., minimizing) constrained non-linear are also known to the skilled reader.

As at least one of the sub-targets is a test sub-target, at least one of the corrected intensities calculated in step 708 represents a measurement having a reduced intrinsic error. If the metrology apparatus forms part of a lithography apparatus, then the calculated corrected intensity can be used to modify the production process of the target.

It will be understood that a sufficient number of measurements need to be taken if the system of equations determined in step 706 are to be solved. In general, the number of measurements should be greater than the number of unknown variables. As has already been implied, this means that it may not be necessary to measure each of the N sub-targets in each of the M portions of the illumination spot. In practice, the number of measurements required for a given number of unknown variables depends on a number of factors:

- the degree with which the equations from step 706 exhibit non-linear behaviour during minimization (greater non-linearity means more measurements are needed);
- the proximity of the initialized values for $I_i, \alpha_j, \gamma_j$ during minimization to a local minimum (closer to a local minimum means the equations exhibit more linear behaviour during minimization);
- the degree of asymmetry of the sub-targets (greater asymmetry means more measurements are needed); and
- the number of additional constraints that can be applied to the system of equations to reduce the number of unknown variables.

It should be understood that, using additional constraints means that solutions are, in principle, possible, even if fewer measurements are made than the number of unknown variables. One such constraint is to normalize the scaling factors $\alpha_j$ based on $\alpha_1$ (i.e., setting $\alpha_1 = 1$). The skilled reader will understand that the normalization can be made with respect to any one of the scaling factors. This normalization step reduces the number of unknown variables by one.

The measurements in step 702 may be of two or more reference sub-targets, each having a known diffraction efficiency, $\eta_i$, where $\eta_i$ is the diffraction efficiency of sub-target $i$, and thus the ratio $\eta_i/\eta_{i'}$ of the diffraction efficiencies of two sub-targets $i$ and $i'$ are known. The ratio $\eta_i/\eta_{i'}$ is also denoted as $r_{ii'}$. In other cases too, the ratio of the diffraction efficiency of two sub-targets may be known, even if their individual diffraction efficiencies are not known. As the ratio between the diffraction efficiencies of two sub-targets is known, one or more of the corrected intensities can be removed, reducing the number of unknown variables by one. For example, referring to Figure 6A, if sub-targets B and C are references, then the ratio of the corrected intensities $I_2$ and $I_3$ is known - it is equal to the known or assumed ratio of the diffraction efficiencies of the sub-targets ($\eta_2/\eta_3$). This means that one of these corrected intensities (either $I_2$ or $I_3$) can be eliminated from the equations determined in step 706. This approach has been found to be effective, especially if the diffraction efficiencies of the reference sub-targets are known to a high degree of accuracy. These constraints can be applied to any of the symmetry cases described below.

The skilled reader will understand that the methods steps of Figure 7 may be performed in any working order and the numbering provided is not intended to impose a strict ordering of the method steps. For example, steps 702 and 704 may be performed together, with intensity measurements being made for each of the plurality of configurations, and step 706 can be determined in advance, before steps 702 and 702 take place.

A distinction is now made between different wafer set-ups and metrology apparatuses, which exhibit varying degrees of asymmetry.

**Symmetric target and symmetric measurement branch (all-symmetric)**

In the event that the measurement branch is symmetric (or can be modelled as such to a first approximation) and the N measured sub-targets are symmetric (e.g., printed symmetrically so that their +1 and -1 diffraction orders are of approximately equal magnitude), the same scaling factors and offset parameters are used for each of the normal and complementary branches, and the measured intensities in step 704 are taken as the sum of the intensities measured by the normal and complementary branches. The equations described above, in relation to Figure 7, represent this "all-symmetric" case.

## Symmetric target and asymmetric measurement branch

In the event that the measurement branch is asymmetric and the $N$ measured sub-targets are symmetric, then the intensity of electromagnetic radiation diffracted by the sub-targets into the normal and complementary branches is the same (i.e. $I_i$ remains unchanged from the all-symmetric case) but the intensities measured by those branches will be different. To account for this asymmetry, separate (i.e., different) scaling factor and offset parameters are used for each of the normal and complementary branches.

Each of the intensities measured in step 704 then includes a first intensity measured by the normal branch and a second intensity measured by the complementary branch. These intensities are denoted $I_{i,j}^{N}$ and $I_{i,j}^{C}$, respectively. The equations determined in step 706 then describe how these intensities ( $I_{i,j}^{N}, I_{i,j}^{C}$ ) are linearly related to the corrected intensities, I;, according to the respective scaling factor and offset parameters ( $\alpha_j^C, \gamma_j^C; \alpha_j^N, \gamma_j^N$ ) in which that sub-target is arranged. That is, $I_{i,j}^{C} \cong \hat{I}_{i,j}^{C} = \alpha_j^C I_i + \gamma_j^C$, and $I_{i,j}^{N} \cong \hat{I}_{i,j}^{N} = \alpha_j^N I_i + \gamma_j^N$. Referring specifically to the example from Figure 6B, this means that $2xNxM$ measurements are taken (i.e., 32 in total, 16 for each of $I_{i,j}^{N}, I_{i,j}^{C}$ ) and there are $2x2xM+N$ unknown variables (i.e., 20 in total, twice as many scaling factors and offset parameters but the same number of corrected intensities).

## Asymmetric target and symmetric measurement branch

In the event that the measurement branch is symmetric and the N measured sub-targets are asymmetric, then the intensity of electromagnetic radiation diffracted by the sub-targets into the normal and complementary branches is different but the effect of each branch on these intensities is commensurate. To account for this asymmetry, a distinction is made between the corrected intensity diffracted by the sub-target (assuming no spot inhomogeneity) into the complementary and normal branches, denoted as $I_i^{C}$ and $I_i^{N}$, respectively. The measured intensities (for example in step 704) may be taken as the sum of the intensities measured by the normal and complementary branches.

As above, each of the intensities measured in step 704 then includes a first intensity measured by the normal branch and a second intensity measured by the complementary branch.

The equations determined in step 706 then describe how these intensities ( $I_{i,j}^{N}, I_{i,j}^{C}$ ) are linearly related to the corrected intensities, $I_i^{C}$ and $I_i^{N}$, respectively according to the respective scaling factor and offset parameters $\alpha_j, \gamma_j$ in which that sub-target is arranged. More specifically, $I_{i,j}^{C} \cong \hat{I}_{i,j}^{C} = \alpha_j I_i^{C} + \gamma_j$, and $I_{i,j}^{N} \cong \hat{I}_{i,j}^{N} = \alpha_j I_i^{N} + \gamma_j$. Referring specifically to the example from Figure 6B, this means that $2xNxM$ measurements are taken (i.e., 32 in total, 16 for each of $I_{i,j}^{N}, I_{i,j}^{C}$ ) and there are $2x(M+N)$ unknown variables (i.e., 16 in total, twice as many corrected intensities but the same number of scaling factors and offset parameters).

As has already been noted, the diffraction efficiency of two or more of the sub-targets may have an assumed or known value. References to diffraction efficiency, in the context of an asymmetric sub-target, refer to the diffraction efficiency, e.g., for the +1 diffraction order, the diffraction efficiency, e.g., for the -1 diffraction order. If two diffraction efficiencies of the sub-targets are known, then up to two unknown variables (e.g., , $I_i^{+1}$ and/or $I_i^{-1}$ ) can be removed from the equations determined in step 706.

## Asymmetric target and asymmetric measurement branch - all asymmetric

In the event that the measurement branch is asymmetric and the $N$ measured sub-targets are symmetric, then the intensity of electromagnetic radiation diffracted by the sub-targets into the normal and complementary branches is the different and the effect of those branches on these intensities is not commensurate (or proportionate). To account for this asymmetry, separate (i.e., different) scaling factor and offset parameters are used for each of the normal and complementary branches, and a distinction is made between the corrected intensity diffracted by the sub-target (assuming no spot inhomogeneity) into the complementary and normal branches, denoted as $I_i^C$ and $I_i^N$, respectively.

As above, each of the intensities measured in step 704 then includes a first intensity measured by the normal branch and a second intensity measured by the complementary branch.

The equations determined in step 706 then describe how these intensities ($I_{i,j}^N$, $I_{i,j}^C$) are linearly related to the corrected intensities, $I_i^C$ and $I_i^N$, respectively according to the respective scaling factor and offset parameters ($\alpha_j^C, \gamma_j^C; \alpha_j^N, \gamma_j^N$). The scaling factor and offset parameters being those that correspond with the measurement branch in which the intensity is measured in step 704 and that correspond with the portion of the illumination spot within which that sub-target is arranged. More specifically, $I_{i,j}^C \cong \hat{I}_{i,j}^C = \alpha_j^C I_i^C + \gamma_j^C$, and $I_{i,j}^N \cong \hat{I}_{i,j}^N = \alpha_j^N I_i^N + \gamma_j^N$. Referring specifically to the example from Figure 6B, this means that *2xNxM* measurements are taken (i.e., 32 in total, 16 for each of $I_{i,j}^N$, $I_{i,j}^C$) and there are *2x2xM+2xN* unknown variables (i.e., 24 in total, twice as many corrected intensities and twice as many scaling factors and offset parameters).

As has already been noted, the diffraction efficiency of two or more of the sub-targets may have an assumed or known value. If two diffraction efficiencies of the sub-targets are known, then up to two unknown variables (e.g., , $I_i^{+1}$ and/or $I_i^{-1}$) can be removed from the equations determined in step 706.

For the asymmetric cases described above, and in particular where the sub-targets are asymmetric, more measurements may be needed to better pose the system of equations that are to be solved in step 708.

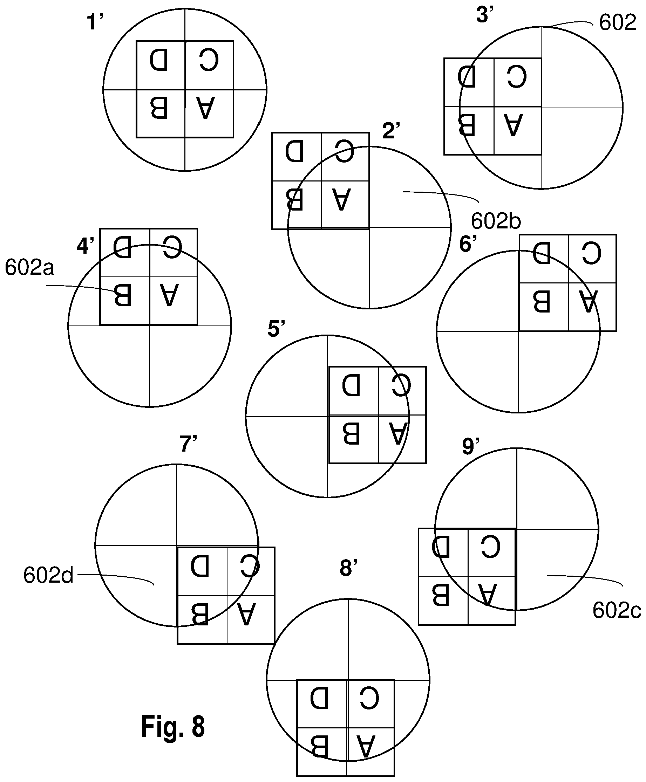

Figure 8 is a schematic illustration, showing the target 600 from Figure 6A arranged in nine further configurations with respect to an illumination spot 602. These are example configurations into which the target may be arranged in step 702 from Figure 7. The configurations are labelled 1' to 9' to distinguish each of the configurations from those shown in Figure 6B. As can be seen from Figure 8, the nine configurations ensure that each sub-target (A, B, C, D) is arranged in each of the respective four portions of the illumination spot exactly once. Table 2 below shows the sub-target (A, B, C, D) that is arranged in each of the four quadrants (602a, 602b, 602c, 602d) for the nine configurations from Figure 8. The sub-targets are denoted A', B', C' and D' in Table 2 to reflect that they are rotationally shifted by $\pi/2$ radians, as compared to the configurations from Figure 6B.

*Table 2*

| Configuration | Quadrant 602a | Quadrant 602b | Quadrant 602c | Quadrant 602d |
|---|---|---|---|---|
| 1' | D' | C' | A' | B' |
| 2' | A' | - | - | - |
| 3' | C' | - | - | A' |
| 4' | B' | A' | - | - |
| 5' | - | D' | B' | - |
| 6' | - | B' | - | - |
| 7' | - | - | D' | - |
| 8' | - | - | C' | D' |
| 9' | - | - | - | C' |

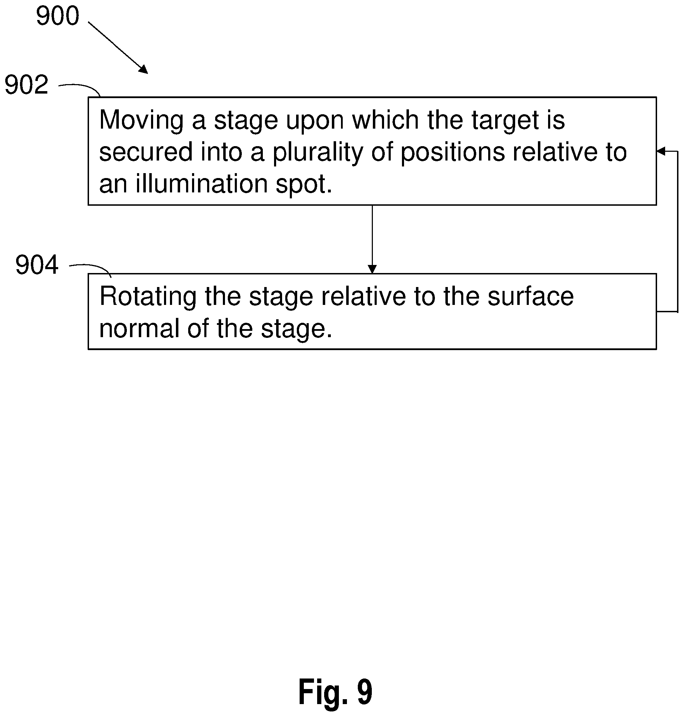

Figure 9 is a method flow diagram 900, for arranging the target relative to the illumination spot in each of a plurality of different configurations, is shown. The method can be performed by a metrology apparatus, such as the one used to perform the method of Figure 7, having a drive arrangement configured to move a sample stage in a first and second translational direction (e.g., along an x and y direction) and configured to rotate the sample stage about its surface normal (e.g., the z direction).

In step 902, the stage is shifted relative to the illumination spot into a plurality of positions in order to position target into a plurality of positions relative to the illumination spot. Method step 902 can be used to arrange the target into the plurality of configurations referred to in step 702 and as shown in Figure 6B, for example. The motion of the stage and target relative to the illumination beam may be adopt a straight or a curved path.

In step 904, the stage is rotated relative to its surface normal. This has the effect of rotating the target relative to the illumination spot. Method step 904 can be used to arrange the target into the plurality of configurations referred to in step 702 and as shown in Figure 8, for example.

The skilled reader will understand that a combination of steps 902 and 904 may be needed to arrange the target into the plurality of configurations, shown in Figure 6B and Figure 8, depending on the order in which the target is arranged into the configurations.

In general, the space available on a wafer is limited. In this regard, having fewer sub-targets arranged on the target is beneficial. The method of the present disclosure is able to accommodate a target with only two sub-targets, provided the scaling factors are normalized, the diffraction efficiency ratio between the two sub-targets is known (i.e., has an assumed value), and the illumination spot is discretized into at least four portions. Three sub-targets only is also possible, even if the illumination spot is discretized into two or three portions.

The method of the present disclosure has been applied to a feature bias target to model how varying focus and/or dose offset affects the intensity of electromagnetic radiation diffracted from two sub-targets, $T_1$ and $T_2$, arranged on the feature bias target. The intensity diffracted by each sub-target (assuming no spot inhomogeneity) is taken to be the first diffraction order, although other diffraction orders can, in principle, be used. These intensities are denoted $I_{T1}$ and $I_{T2}$, respectively. $I_{T1}$ and $I_{T2}$ can be determined according to the method of Figure 7, using simulated or measured (i.e. real world value) intensities at the metrology sensor(s) of the metrology apparatus.

The resulting intensity profile for $I_{T1}$ and $I_{T2}$ (i.e., intensity against focus and/or dose offset) is known as a Bossung curve. The difference between these intensity profiles ($I_{T1}$-$I_{T2}$), at a given focus and/or dose offset, is referred to herein as a "dI metric". In some examples, the value of the dI metric is normalized according to the sum of the intensities $I_{T1}$ and $I_{T2}$ at that focus and/or dose offset.

"SpoHo scaling" and "SpoHo scaling and SpoHo offset" are known methods to determine the offset parameters and scaling factors, from which the intensities $I_{T1}$ and $I_{T2}$ (and hence the dI metric) can be determined, using simulated or measured intensities at the metrology sensor(s) of the metrology apparatus. These calibration techniques serve as a comparison to the approach of this disclosure. In both "SpoHo scaling" and "SpoHo scaling and SpoHo offset", the scaling factors are determined from a common SpoHo scaling map. In some examples, each scaling factor is computed as the mean scaling factor over the map across a given measurement pad. In "SpoHo scaling and SpoHo offset", an offset parameter is determined from a ghost. In some examples, the offset parameter is computed as the average ghost intensity across a given measurement pad. In "SpoHo scaling and SpoHo offset", the scaling factors and offset parameters are determined separately, which has already been noted above, leads to biasing in their fitting.

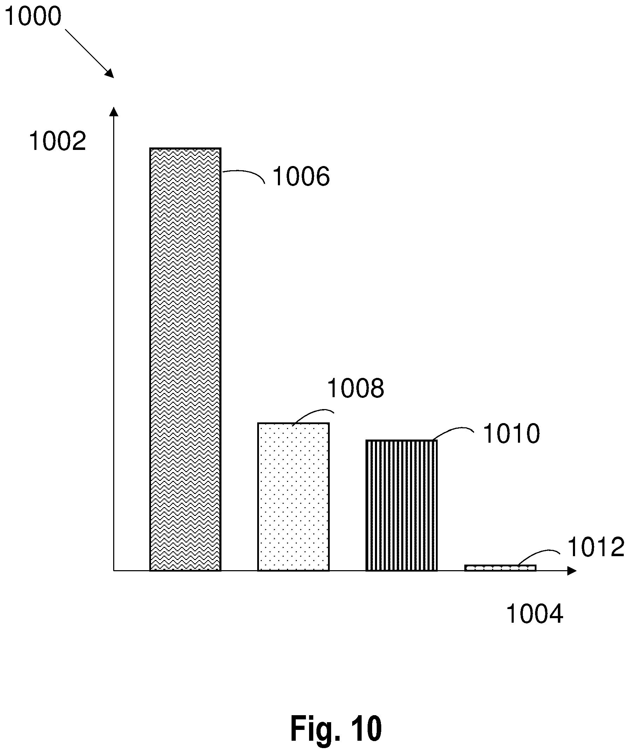

Figure 10 is a histogram 1000, showing simulated values for the root-mean-square error (RMSE) 1002 between the assumed dI metric and the dI metric computed according to the following calibration techniques 1004, across a focus and/or dose offset range. The calibration techniques are: no calibration 1006, SpoHo scaling 1008, SpoHo scaling and offset 1010, and the holistic approach 1012 of this disclosure. As can be seen, the RMSE for the holistic approach of this disclosure is much less than the RMSE of the "SpoHo scaling" and "SpoHo scaling and offset" calibration techniques. In a wholly simulated model (i.e. where no real-world measurements are taken and the system is aberration-free), the RMSE for approach 1012 can be zero. The RMSE for the "SpoHo scaling and offset" is marginally less than for "SpoHo scaling", although they are comparable in magnitude. The improvement of introducing an offset parameter is, therefore, a marginal one. It is observed that SpoHo calibration techniques introduce a tilting of the dI metric profile with respect to the assumed dI metric profile (i.e., the profile gradients differ). In other words, the dI metric profile determined according to the SpoHo calibration techniques fits some focus and/or dose offsets better than others - typically with the misfit increasing with increasing focus and/or dose offset. On the other hand, the holistic approach of the present disclosure determines the scaling factors and offset parameters holistically (e.g., at the same time), which means the assumed dI metric profile can be fit much more closely and without tilting.

Further embodiments are disclosed in the subsequent list of numbered clauses:

> 1. A method for performing a measurement of a sub-target arranged on a target, the target comprising a plurality of sub-targets, the method comprising:

>> arranging the target relative to an illumination spot of electromagnetic radiation in each of a plurality of different configurations to thereby illuminate each of the sub-targets in different respective portions of the illumination spot, wherein, for each configuration, at least one of the sub-targets is illuminated by a respective portion of the illumination spot;

measuring, for each configuration, an intensity of electromagnetic radiation diffracted from each respective sub-target, said sub-target being arranged in a respective portion of the illumination spot; and
determining a corrected intensity of electromagnetic radiation diffracted from each of the sub-targets.

2. The method of clause 1, wherein the step of determining a corrected intensity comprises:

determining, for each measured intensity, an equation mapping the corrected intensity of electromagnetic radiation to the measured intensity, according to a scaling factor and an offset parameter for the respective portion in which the respective sub-target is arranged; and
calculating (i) the scaling factor and offset parameter, for each of the respective portions of the illumination spot, and (ii) a corrected intensity of electromagnetic radiation diffracted from each of the sub-targets, by solving a system of equations comprising the determined equations.

3. The method of clause 1 or 2, wherein the step of measuring the intensity of electromagnetic radiation for each configuration comprises:

measuring a first intensity corresponding to a diffraction order, m, of electromagnetic radiation diffracted from the respective sub-target, wherein m is a positive integer; and
measuring a second intensity corresponding to a diffraction order, -m, of electromagnetic radiation diffracted from the respective sub-target.

4. The method of clause 3, when dependent on clause 2, wherein the step of determining the equation for each measured intensity comprises:

determining a respective equation for each of the first and second measured intensities, and
wherein calculating the scaling factor and offset parameter for each of the respective portions of the illumination spot comprises:
calculating a respective scaling factor and a respective offset parameter for each of the first and second measured intensities.

5. The method of clause 4, wherein calculating the corrected intensity of electromagnetic radiation diffracted from each of the sub-targets comprises:

determining a first corrected intensity for the first measured intensities; and
determining a second corrected intensity for the second measured intensities.

6. The method of any one of the preceding clauses, wherein the plurality of different configurations of the target relative to the illumination spot comprise configurations which differ in translational position of the target relative to the illumination spot.

7. The method of clause 6, wherein the plurality of different configurations of the target relative to the illumination spot comprise configurations which differ by the rotational position of the target relative to the illumination differing by $\pi/2$ radians.

8. The method of any one of the preceding clauses, when dependent on clause 2, wherein the system of equations is solved by:
minimising a loss function indicative of a discrepancy between estimated measured intensities and the corresponding measured intensities, wherein each estimated measured intensity is based on the corresponding corrected intensity, the scaling factor and the offset parameter.

9. The method of clauses 7 or 8, when dependent on clause 3, wherein the measured intensities include each of the first measured intensities and each of the second measured intensities and wherein the estimated measured intensities are respective estimates for each one of these measured intensities.

10. The method of any one of clauses 3 to 9, wherein the positive integer, m, is equal to 1.

11. The method of any one of the preceding clauses, wherein the scaling factors are normalised by a scaling factor in one of the respective portions of the illumination spot and a diffraction efficiency ratio between two of the sub-targets is an assumed value.

12. The method of any one of clauses 1 to 10, wherein the target comprises at least four sub-targets, and wherein optionally the scaling factors are normalised by a scaling factor in one of the respective portions of the illumination spot and a diffraction efficiency ratio between at least three sub-targets is an assumed value.

13. The method of clause 11, wherein the target comprises two sub-targets.

14. The method of any one of clauses 1 to 10, wherein the target comprises three sub-targets and the respective portions are sectors of the illumination spot, each sector being a unit fraction of the illumination spot and wherein the unit fraction is less than or equal to a third.

15. The method of clause 14, wherein the unit fraction is a quarter.

16. The method of any one of the preceding clauses, wherein the target comprises three sub-targets, each respective portion is a disjunct half of the illumination spot, and either: (i) the two scaling factors are normalised by one of the scaling factors; or (ii) a diffraction efficiency ratio between two sub-targets is an assumed value.

17. The method of clause 11, wherein the target comprises three sub-targets.

18. The method according to any one of the preceding clauses, wherein the corrected intensity of electromagnetic radiation diffracted from each sub-target characterizes a metrology parameter of the sub-target.

19. The method according to clause 18, further comprising:

modifying a production process of the target according to the or each corrected intensity, to correct the metrology parameter of one or more of the sub-targets.

20. The method of any one of the preceding clauses, in which the target is a product of a lithographic production process performed by a lithography apparatus.

21. The method of clause 20 when dependent on clause 18, in which the metrology parameter is a parameter characterizing one or both of (1) the quality of focus and (2) dose, of the lithography apparatus when fabricating the sub-target.

22. The method of clause 20 when dependent on clause 18, in which the metrology parameter is a parameter characterizing overlay of two elements of the sub-target.

23. An apparatus, comprising:

a stage configured to secure a target comprising a plurality of sub-targets;

an illumination branch configured to provide an illumination spot of electromagnetic radiation onto the sample stage;

a drive arrangement configured to arrange the target relative to the illumination spot of electromagnetic radiation in each of a plurality of different configurations to thereby illuminate each of the sub-targets in different respective portions of the illumination spot, wherein, for each configuration, at least one of the sub-targets is illuminated by a respective portion of the illumination spot;

a measurement branch configured to measure, for each configuration, an intensity of electromagnetic radiation diffracted from each respective sub-target, said sub-target being arranged in a respective portion of the illumination spot; and

one or more processors configured to determine a corrected intensity of electromagnetic radiation diffracted for each of the sub-targets.

24. The apparatus of clause 23, further comprising:

a memory configured to store the measured intensities for each configuration.

25. The apparatus of any one of clauses 23 to 24, wherein the apparatus further comprises a lithography apparatus for fabricating the target.

26. A non-transitory computer program product comprising machine-readable instructions therein, the instructions, upon execution by a computer system, configured to cause the computer system to at least cause performance of the method of any of clauses 1-22.

It should be appreciated that the term color is used throughout this text synonymously with wavelength or spectral component and the colors may include those outside the visible band (e.g., infrared or ultraviolet wavelengths).

While specific embodiments of the invention have been described above, it will be appreciated that the invention may be practiced otherwise than as described.

Although specific reference may have been made above to the use of embodiments of the invention in the context of optical lithography, it will be appreciated that the invention may be used in other applications, for example imprint lithography, and where the context allows, is not limited to optical lithography. In imprint lithography a topography in a patterning device defines the pattern created on a substrate. The topography of the patterning device may be pressed into a layer of resist supplied to the substrate whereupon the resist is cured by applying electromagnetic radiation, heat, pressure or a combination thereof. The patterning device is moved out of the resist leaving a pattern in it after the resist is cured.

The terms "radiation" and "beam" used herein encompass all types of electromagnetic radiation, including ultraviolet (UV) radiation (e.g., having a wavelength of or about 365, 355, 248, 193, 157 or 126 nm) and extreme ultra-violet (EUV) radiation (e.g., having a wavelength in the range of 1-100 nm), as well as particle beams, such as ion beams or electron beams.

The term "lens", where the context allows, may refer to any one or combination of various types of optical components, including refractive, reflective, magnetic, electromagnetic and electrostatic optical components. Reflective components are likely to be used in an apparatus operating in the UV and/or EUV ranges.

The breadth and scope of the present invention should not be limited by any of the above-described exemplary embodiments, but should be defined only in accordance with the following claims and their equivalents. Additional objects, advantages and features of the present invention are set forth in this specification, and in part will become apparent to those skilled in the art on examination of the following, or may be learned by practice of the invention. The inventions disclosed in this application are not limited to any particular set of, or combination of, objects, advantages and features. It is contemplated that various combinations of the stated objects, advantages and features make up the inventions disclosed in this application.

**Claims**

1. A method for performing a measurement of a sub-target arranged on a target, the target comprising a plurality of sub-targets, the method comprising:

   arranging the target relative to an illumination spot of electromagnetic radiation in each of a plurality of different configurations to thereby illuminate each of the sub-targets in different respective portions of the illumination spot, wherein, for each configuration, at least one of the sub-targets is illuminated by a respective portion of the illumination spot;
   measuring, for each configuration, an intensity of electromagnetic radiation diffracted from each respective sub-target, said sub-target being arranged in a respective portion of the illumination spot; and
   determining a corrected intensity of electromagnetic radiation diffracted from each of the sub-targets.

2. The method of claim 1, wherein the plurality of different configurations of the target relative to the illumination spot comprise configurations which differ in translational position of the target relative to the illumination spot.

3. The method of claim 2, wherein the plurality of different configurations of the target relative to the illumination spot comprise configurations which differ by the rotational position of the target relative to the illumination differing by $\pi/2$ radians.

4. The method of any one of the preceding claims, wherein the target comprises at least four sub-targets.

5. The method of any one of claims 1 to 3, wherein the target comprises two sub-targets.

6. The method of any one of claims 1 to 3, wherein the target comprises three sub-targets.

7. The method according to any one of the preceding claims, wherein the corrected intensity of electromagnetic radiation diffracted from each sub-target characterizes a metrology parameter of the sub-target.

8. The method of any one of the preceding claims, in which the target is a product of a lithographic production process performed by a lithography apparatus.

9. The method of claim 8 when dependent on claim 7, in which the metrology parameter is a parameter characterizing the quality of focus of the lithography apparatus when fabricating the sub-target.

10. The method of claim 8 when dependent on claim 7, in which the metrology parameter is a parameter characterizing dose of the lithography apparatus when fabricating the sub-target.

11. The method of claim 8 when dependent on claim 7, in which the metrology parameter is a parameter characterizing overlay of two elements of the sub-target.

12. A non-transitory computer program product comprising machine-readable instructions therein, the instructions, upon execution by a computer system, configured to cause the computer system to at least cause performance of the method of any of clauses 1-11.

13. An apparatus, comprising:

a stage configured to secure a target comprising a plurality of sub-targets;

an illumination branch configured to provide an illumination spot of electromagnetic radiation onto the sample stage;

a drive arrangement configured to arrange the target relative to the illumination spot of electromagnetic radiation in each of a plurality of different configurations to thereby illuminate each of the sub-targets in different respective portions of the illumination spot, wherein, for each configuration, at least one of the sub-targets is illuminated by a respective portion of the illumination spot;

a measurement branch configured to measure, for each configuration, an intensity of electromagnetic radiation diffracted from each respective sub-target, said sub-target being arranged in a respective portion of the illumination spot; and

one or more processors configured to determine a corrected intensity of electromagnetic radiation diffracted for each of the sub-targets.

14. The apparatus of claim 13, further comprising:

a memory configured to store the measured intensities for each configuration.

15. The apparatus of claim 13 or 14, wherein the apparatus further comprises a laser produced plasma (LPP) source.

Fig. 1

Fig. 2

# Fig. 3

# Fig. 4

Fig. 5

610

600

| A | B |
|---|---|
| C | D |

**Fig. 6A**

Fig. 6B

700

702

Arranging a target relative to an illumination spot in each of a plurality of different configurations.

704

For each configuration, measuring the intensities of electromagnetic radiation diffracted from each of the sub-targets.

705

Determining corrected intensities.

708

Solving the system of equations to calculate each of the corrected intensities, and scaling factor and offset parameter pairings.

706

For each measured intensity, determining an equation that maps a corrected intensity of electromagnetic radiation to the measured one, according to a scaling factor and offset parameter pairing.

**Fig. 7**

EP 4 571 418 A1

Fig. 8

900

902 — Moving a stage upon which the target is secured into a plurality of positions relative to an illumination spot.

904 — Rotating the stage relative to the surface normal of the stage.

**Fig. 9**

1000

1002

1006

1008

1010

1012

1004

**Fig. 10**

Europäisches
Patentamt

European
Patent Office

Office européen
des brevets

# EUROPEAN SEARCH REPORT

**Application Number**

EP 23 21 5687

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | WO 2010/031510 A1 (ASML NETHERLANDS BV [NL]; BHATTACHARYYA KAUSTUVE [NL] ET AL.) 25 March 2010 (2010-03-25) * paragraphs [0043] - [0048]; figures 6, 7 * | 1-15 | INV. G03F7/20 |
| X | WO 2022/122546 A1 (ASML NETHERLANDS BV [NL]) 16 June 2022 (2022-06-16) | 12 | |
| A | * paragraphs [0057] - [0066]; claim 10; example 7 * | 1-11, 13-15 | |
| A | "CROSS-TALK COMPENSATION IN EUV BASED METROLOGY WITH FINITE-SIZED TARGETS", RESEARCH DISCLOSURE, KENNETH MASON PUBLICATIONS, HAMPSHIRE, UK, GB, vol. 645, no. 29, 6 December 2017 (2017-12-06), page 35, XP007146216, ISSN: 0374-4353 [retrieved on 2017-12-06] * the whole document * | 1-15 | |

**TECHNICAL FIELDS SEARCHED (IPC)**

G03F

The present search report has been drawn up for all claims

| Place of search | Date of completion of the search | Examiner |
|---|---|---|
| Munich | 17 June 2024 | Eisner, Klaus |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 23 21 5687

This annex lists the patent family members relating to the patent documents cited in the above-mentioned European search report.
The members are as contained in the European Patent Office EDP file on
The European Patent Office is in no way liable for these particulars which are merely given for the purpose of information.

17-06-2024

| Patent document cited in search report | Publication date | Patent family member(s) | Publication date |
|---|---|---|---|
| WO 2010031510 A1 | 25-03-2010 | NL 2003404 A | 17-03-2010 |
| | | US 2011229830 A1 | 22-09-2011 |
| | | WO 2010031510 A1 | 25-03-2010 |
| WO 2022122546 A1 | 16-06-2022 | CN 116569111 A | 08-08-2023 |
| | | IL 303221 A | 01-07-2023 |
| | | JP 2023551776 A | 13-12-2023 |
| | | KR 20230113565 A | 31-07-2023 |
| | | TW 202240302 A | 16-10-2022 |
| | | US 2024036484 A1 | 01-02-2024 |
| | | WO 2022122546 A1 | 16-06-2022 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2006033921 A1
- US 2010201963 A1
- US 2006066855 A1
- WO 2009078708 A
- WO 2009106279 A
- US 20110027704 A
- US 20110043791 A
- US 2011102753 A1
- US 20120044470 A
- US 20120123581 A
- US 20130258310 A
- US 20130271740 A
- WO 2013178422 A1
- US 6952253 B
- US 20100328655 A
- US 20110249244 A
- US 20110026032 A
- EP 1628164 A
- US 451599
- US 11708678 B
- US 12256780 B
- US 12486449 B
- US 12920968 B
- US 12922587 B
- US 13000229 B
- US 13033135 B
- US 13533110 B
- US 13891410 B
- WO 2011012624 A
- US 20160161863 A
- US 20160370717 A1